# EUROPÄISCHE PATENTANMELDUNG

(11) **EP 4 202 753 A1**
(43) Veröffentlichungstag der Anmeldung: **28.06.2023**
(21) Anmeldenummer: 21216219.2
(22) Anmeldetag: 21.12.2021
(51) Int. Cl.: G06F 30/15, G06F 30/20, G06F 17/40, G09B 9/54, G09B 9/05, G06F 11/36

(54) **ERZEUGEN VON TESTDATEN ZUM TESTEN EINES EINEN SENSORDATENSTROM AUSWERTENDEN STEUERSYSTEMS EINES KRAFTFAHRZEUGS**

(71) Anmelder: dSPACE GmbH, 33102 Paderborn (DE)
(72) Erfinder: Liem, Kusnadi, 33102 Paderborn (DE); Meyer, Norbert, 33102 Paderborn (DE)

(57) **Zusammenfassung**

Die Erfindung betrifft ein computerimplementiertes Verfahren zum Erzeugen von Testdaten zum Testen eines einen Sensordatenstrom auswertenden Steuersystems eines Kraftfahrzeugs, mit folgenden Verfahrensschritten:
simuliertes Durchfahren wenigstens eines Teils einer virtuellen Simulationsumgebung mit einem einen virtuellen Sensor (2) tragenden virtuellen Fahrzeug (1) durch Vorgabe einer translatorischen Bewegung des virtuellen Fahrzeugs (1) in der virtuellen Simulationsumgebung, wobei der virtuelle Sensor (2) einen Sichtbereich (3) aufweist, in dem er die virtuelle Simulationsumgebung erfasst,
Erzeugen synthetischer Sensordaten mit dem virtuellen Sensor (2) durch Erfassen der von dem virtuellen Fahrzeug (1) durchfahrenen virtuellen Simulationsumgebung in dem Sichtbereich des virtuellen Sensors (2) und
Bereitstellen der synthetischen Sensordaten als Testdaten zum Testen eines einen Sensordatenstrom auswertenden Steuersystems eines Kraftfahrzeugs, wobei
im Schritt des Durchfahrens wenigstens eines Teils der virtuellen Simulationsumgebung mit dem den virtuellen Sensor (2) tragenden virtuellen Fahrzeug (1) wenigstens eine durch die translatorische Bewegung des virtuellen Fahrzeugs (1) hervorgerufene Fahrzeugdynamikbewegung ermittelt wird, wobei die Fahrzeugdynamikbewegung ein Nicken und/oder ein Gieren und/oder ein Wanken und/oder ein Vertikalbewegen des virtuellen Fahrzeugs (1) umfasst, und
im Schritt des Erzeugens der synthetischen Sensordaten mit dem virtuellen Sensor (2) die durch die simulierte Fahrzeugdynamikbewegung des virtuellen Fahrzeugs (1) verursachte Veränderung des Sichtbereichs (3) des virtuellen Sensors (2) berücksichtigt wird, in dem der virtuelle Sensor (1) die von dem virtuellen Fahrzeug (1) durchfahrene virtuelle Simulationsumgebung erfasst.

Auf diese Weise wird eine Möglichkeit bereitgestellt, im Rahmen einer Simulation solche Testdaten zum Beaufschlagen eines zu testenden Steuergeräts zu erhalten, die von Daten, die mittels eines realen Systems erhalten worden wären, möglichst wenig abweichen.

## Beschreibung

Die Erfindung betrifft ein computerimplementiertes Verfahren zum Erzeugen von Testdaten zum Testen eines einen Sensordatenstrom auswertenden Steuersystems eines Kraftfahrzeugs, mit folgenden Verfahrensschritten:
simuliertes Durchfahren wenigstens eines Teils einer virtuellen Simulationsumgebung mit einem einen virtuellen Sensor tragenden virtuellen Fahrzeug durch Vorgabe einer translatorischen Bewegung des virtuellen Fahrzeugs in der virtuellen Simulationsumgebung, wobei der virtuelle Sensor einen Sichtbereich aufweist, in dem er die virtuelle Simulationsumgebung erfasst,
Erzeugen synthetischer Sensordaten mit dem virtuellen Sensor durch Erfassen der von dem virtuellen Fahrzeug durchfahrenen virtuellen Simulationsumgebung in dem Sichtbereich des virtuellen Sensors und
Bereitstellen der synthetischen Sensordaten als Testdaten zum Testen eines einen Sensordatenstrom auswertenden Steuersystems eines Kraftfahrzeugs.

Die Erfindung ist relevant für das technische Gebiet des Entwickelns und Testens von Fahrassistenzsystem für das autonome Fahren oder das teilautonome Fahren eines Kraftfahrzeugs. Ein Kraftfahrzeug, das zum autonomen oder teilautonomen Fahren geeignet ist, weist im Allgemeinen ein Sensorsystem zum Erfassen von Objekten in der Umgebung des Fahrzeugs auf und wird wenigstens teilweise aufgrund von dem Sensorsystem erfasster Signale gesteuert. Entsprechende Sensoren eines solchen Sensorsystems des Kraftfahrzeugs sind im Allgemeinen Ultraschallsensoren, LIDAR-Sensoren, RADAR-Sensoren und/oder Kameras, mit denen die Umgebung des Kraftfahrzeugs erfasst wird, um damit ein autonomes oder zumindest teilautonomes Fahren des Testfahrzeugs zu erzielen. Entsprechende Sensorsysteme sind außerdem Systeme zum Empfang von Daten von anderen Fahrzeugen oder stationären Vorrichtungen des Straßenverkehrs, um durch Auswertung der Daten ein autonomes oder zumindest teilautonomes Fahren des Fahrzeugs zu erzielen (Car2X-Kommunikation).

Beim autonomen Fahren muss der Fahrer, zumindest über lange Strecken, gar nicht mehr in den Fahrprozess eingreifen. Beim teilautonomen Verfahren ist es zumindest so, dass das Fahrzeug automatisch, also ohne Eingriff des Fahrers, auf bestimmte Verkehrssituationen reagiert und damit z.B. eine Kollision mit einem vorausfahrenden langsameren Fahrzeug vermeidet, indem bei Annäherung an dieses vorausfahrende Fahrzeug automatisch ein Bremsvorgang eingeleitet wird. Um derartige automatisierte Fahrmanöver durchführen zu können, wird mit Hilfe der Sensoren des Sensorsystems erfasst, wo sich in der Umgebung des Fahrzeugs andere Fahrzeuge, Fußgänger oder andere Hindernisse befinden.

Bevor ein Fahrzeug, das mit einem entsprechenden Sensorsystem ausgerüstet ist, in der Praxis, also auf dem realen Straßennetz, zum teilautonomen oder autonomen Fahren betrieben werden kann, müssen eine Vielzahl von Tests durchgeführt werden, um sicherzustellen, dass das teilautonome bzw. autonome Fahren tatsächlich verlässlich und sicher ist. Zwar erfolgen derartige Tests, typischerweise in einem fortgeschrittenen Stadium, auch auf öffentlichen Straßen mit realen Fahrzeugen. Vorab werden in der Regel jedoch Tests in Form von Simulationen durchgeführt, und zwar mit einem virtuellen Fahrzeug, das sich in einer virtuellen dreidimensionalen Simulationsumgebung bewegt. Um die Reaktion des Sensorsystems für eine hohe Anzahl unterschiedlicher, auch unvorhergesehener, Situationen zu überprüfen, ist es gewünscht, derartige Tests randomisiert und möglichst realitätsnah durchzuführen.

Daher ist es die Aufgabe der Erfindung, eine Möglichkeit bereitzustellen, im Rahmen einer Simulation solche Testdaten zum Beaufschlagen eines zu testenden Steuergeräts zu erhalten, die von Daten, die mittels eines realen Systems erhalten worden wären, möglichst wenig abweichen.

Diese Aufgabe wird durch die Gegenstände der unabhängigen Patentansprüche gelöst. Bevorzugte Weiterbildungen finden sich in den Unteransprüchen.

Erfindungsgemäß wird somit ein computerimplementiertes Verfahren zum Erzeugen von Testdaten zum Testen eines einen Sensordatenstrom auswertenden Steuersystems eines Kraftfahrzeugs bereitgestellt, das folgende Verfahrensschritte aufweist:
simuliertes Durchfahren wenigstens eines Teils einer virtuellen Simulationsumgebung mit einem einen virtuellen Sensor tragenden virtuellen Fahrzeug durch Vorgabe einer translatorischen Bewegung des virtuellen Fahrzeugs in der virtuellen Simulationsumgebung, wobei der virtuelle Sensor einen Sichtbereich aufweist, in dem er die virtuelle Simulationsumgebung erfasst,
Erzeugen synthetischer Sensordaten mit dem virtuellen Sensor durch Erfassen der von dem virtuellen Fahrzeug durchfahrenen virtuellen Simulationsumgebung in dem Sichtbereich des virtuellen Sensors und
Bereitstellen der synthetischen Sensordaten als Testdaten zum Testen eines einen Sensordatenstrom auswertenden Steuersystems eines Kraftfahrzeugs, wobei
im Schritt des Durchfahrens wenigstens eines Teils der virtuellen Simulationsumgebung mit dem den virtuellen Sensor tragenden virtuellen Fahrzeug wenigstens eine durch die translatorische Bewegung des virtuellen Fahrzeugs hervorgerufene Fahrzeugdynamikbewegung ermittelt wird, wobei die Fahrzeugdynamikbewegung ein Nicken und/oder ein Gieren und/oder ein Wanken und/oder ein Vertikalbewegen des virtuellen Fahrzeugs umfasst, und
im Schritt des Erzeugens der synthetischen Sensordaten mit dem virtuellen Sensor die durch die simulierte Fahrzeugdynamikbewegung des virtuellen Fahrzeugs verursachte Veränderung des Sichtbereichs des virtuellen Sensors berücksichtigt wird, in dem der virtuelle Sensor die von dem virtuellen Fahrzeug durchfahrene virtuelle Simulationsumgebung erfasst.

Die vorliegende Erfindung berücksichtigt also bei der Simulation auch die Dynamik des Fahrzeugs und wenigstens eine damit verbundene Bewegung. Dazu müssen die am Fahrzeug wirkenden Kräften ermittelt werden. Um diese genau definiert anzugeben, ist es üblich, für das Kraftfahrzeug ein Koordinatensystem zu verwenden. Durch die Einführung eines solchen Fahrzeugkoordinatensystems wird für Kräfte, Momente, Geschwindigkeiten und Wege jeweils eine Richtung definiert. Dieses Koordinatensystem wird beispielsweise in den Schwerpunkt des Fahrzeugs gelegt, wobei die x-Achse in Fahrtrichtung und die z-Achse nach oben zeigt. Das Koordinatensystem ist in der Regel rechtshändig ausgerichtet, so dass die y-Achse in Fahrtrichtung nach links zeigt. Eine Bewegung in x-Richtung ist eine Längsbewegung. Bewegt sich das Fahrzeug in y-Richtung, dann spricht man vom Schieben. Bei einer Bewegung in z-Richtung handelt es sich um eine Hubbewegung, im Folgenden auch als Vertikalbewegen bezeichnet.

An einem fahrenden Fahrzeug können aber nicht nur gerichtete Bewegungen, sondern auch Momente um die oben genannten drei Koordinatenachsen auftreten. Bei einem Kraftfahrzeug nennt man eine Bewegung um die x-Achse Wanken, eine Bewegung um die y-Achse Nicken und eine Bewegung um die z-Achse Gieren. In der Fahrdynamik gibt es also sechs Freiheitsgrade, nämlich drei translatorische (Längsbewegung, Schieben, Vertikalbewegen) und drei rotatorische (Gieren, Nicken und Wanken). Erfindungsgemäß erfolgt eine Vorgabe einer translatorischen Bewegung des virtuellen Fahrzeugs auf einer virtuellen Straße in x- und y-Richtung und die Bewegungen in wenigstens einer der vier anderen Freiheitsgrade werden auf der Grundlage der vorgegebenen translatorischen Bewegung des virtuellen Fahrzeugs ermittelt.

Die Ermittlung solcher Fahrdynamikbewegungen auf der Grundlage einer vorgegebenen translatorischen Bewegung ist dem Fachmann aus der Praxis gut bekannt und bedarf daher vorliegend keiner weiteren Erläuterungen. Exemplarisch sei diesbezüglich auf das Dokument "Christoph WEIDEMANN, State-of-the-Art Railway Vehicle Design with Multi-Body Simulation, Journal of Mechanical Systems for Transportation and Logistics, Vol. 3, No. 1, 2010" hingewiesen.

Maßgeblich für die Erfindung ist nun, dass im Schritt des Erzeugens synthetischer Sensordaten mit dem virtuellen Sensor die durch die simulierte Fahrzeugdynamikbewegung des virtuellen Fahrzeugs verursachte Veränderung des Sichtbereichs des virtuellen Sensors berücksichtigt wird. Damit wird es ermöglicht, die Fahrzeugdynamik bei dem Erzeugen der Testdaten zum Testen des Steuersystems zu berücksichtigen, was insbesondere in Extremsituationen von besonderem Interesse sein kann, wie bei einem starken Abbremsen, bei dem sich der Sensor aufgrund des Nickens des Fahrzeugs so nach vorne neigt, dass die Umgebung des Fahrzeugs nur noch in einem weniger weit von dem Fahrzeug entfernten Bereich als vorher, also während einer normalen Fahrt des Fahrzeugs, erfassbar ist.

Grundsätzlich kann der virtuelle Sensor die Simulation unterschiedlicher von einem Kraftfahrzeug getragener Sensoren sein. Gemäß einer bevorzugten Weiterbildung der Erfindung ist jedoch vorgesehen, dass der virtuelle Sensor ein virtueller Ultraschallsensor, ein virtueller LIDAR-Sensor, ein virtueller RADAR-Sensor oder eine virtuelle Kamera ist. Dabei umfasst die Erfindung freilich auch derartige Situationen, in denen eine Mehrzahl von virtuellen Sensoren von dem virtuellen Fahrzeug getragen werden.

Die virtuelle Simulationsumgebung kann unterschiedlich ausgestaltet sein. Gemäß einer bevorzugten Weiterbildung der Erfindung gilt jedoch, dass die virtuelle Simulationsumgebung dreidimensional ist. Dabei ist es ganz besonders bevorzugt, dass die dreidimensionale virtuelle Simulationsumgebung eine virtuelle Straße mit Gefälle umfasst, auf der das virtuelle Fahrzeug fährt. Auf diese Weise kann es nicht nur zu Wankbewegungen, zu Nickbewegungen und zu Gierbewegungen sondern auch zu einem Vertikalbewegen des Fahrzeugs kommen.

Gemäß einer bevorzugten Weiterbildung der Erfindung wird beim Ermitteln der durch die translatorische Bewegung des virtuellen Fahrzeugs hervorgerufenen Fahrzeugdynamikbewegung Folgendes berücksichtigt: die Masse des virtuellen Fahrzeugs und/oder die Geometrie des virtuellen Fahrzeugs und/oder die Masseverteilung des virtuellen Fahrzeugs und/oder die Federung des virtuellen Fahrzeugs und/oder die Dämpfung des virtuellen Fahrzeugs. Insbesondere gilt hier, dass je genauer die Masseverteilung des virtuellen Fahrzeugs der Masseverteilung des realen Fahrzeugs entspricht, umso realitätsgetreuer die Bewegungen des Fahrzeugs simuliert werden können.

Grundsätzlich könnte die virtuelle Simulationsumgebung in Echtzeit im Rahmen der Simulation erstellt werden. Gemäß einer bevorzugten Weiterbildung der Erfindung ist jedoch vorgesehen, dass die virtuelle Simulationsumgebung vorab erstellt und auf einem nichtflüchtigen, computerlesbaren Speichermedium abgespeichert ist.

Die Befestigung des virtuellen Sensors an dem virtuellen Fahrzeug kann grundsätzlich flexibel sein. Gemäß einer bevorzugten Weiterbildung Erfindung ist jedoch vorgesehen, dass der virtuelle Sensor starr an dem virtuellen Fahrzeug befestigt ist. Auf diese Weise werden alle Bewegungen des virtuellen Fahrzeugs direkt auf den virtuellen Sensor übertragen.

Die Erfindung betrifft auch ein nichtflüchtiges, computerlesbares Speichermedium mit darauf abgespeicherten synthetischen Sensordaten, die mit einem Verfahren, wie zuvor beschrieben, erhalten worden sind.

Außerdem betrifft die Erfindung eine Verwendung der auf dem nichtflüchtigen, computerlesbaren Speichermedium abgespeicherten synthetischer Sensordaten zum Testen eines einen Sensordatenstrom auswertenden Steuersystems. Vorzugsweise ist bei einer solchen Verwendung das einen Sensordatenstrom auswertende Steuersystem ein Fahrerassistenzsystem für ein Kraftfahrzeug oder eine Komponente eines solchen Fahrassistenzsystems, beispielsweise ein Perzeptionsalgorithmus oder ein als Klassifikator eingerichtetes neuronales Netz.

Nachfolgend wird die Erfindung anhand eines bevorzugten Ausführungsbeispiels unter Bezugnahme auf die Zeichnungen weiter im Detail erläutert. In den Zeichnungen zeigen:
- Fig. 1: schematisch ein Verfahren gemäß einem bevorzugten Ausführungsbeispiel der Erfindung,
- Fig. 2a: schematisch eine normale Fahrt eines virtuellen Kraftfahrzeugs und
- Fig. 2b: schematisch eine Vollbremsung eines virtuellen Kraftfahrzeugs.

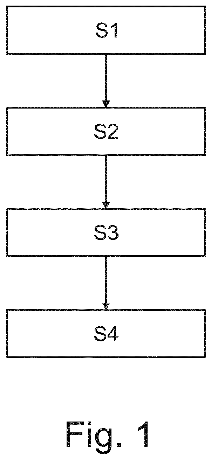

Aus Fig. 1 ist schematisch ein Verfahren gemäß einem bevorzugten Ausführungsbeispiel der Erfindung ersichtlich. Dabei handelt es sich um ein computerimplementiertes Verfahren zum Erzeugen von Testdaten zum Testen eines einen Sensordatenstrom auswertenden Steuersystems eines Kraftfahrzeugs.

In einem ersten Verfahrensschritt S1 erfolgt ein simuliertes Durchfahren wenigstens eines Teils einer dreidimensionalen virtuellen Simulationsumgebung mit einem einen virtuellen Sensor tragenden virtuellen Fahrzeug durch Vorgabe einer translatorischen Bewegung des virtuellen Fahrzeugs in der virtuellen Simulationsumgebung. Die virtuelle Simulationsumgebung ist dabei vorab erstellt und auf einem nichtflüchtigen, computerlesbaren Speichermedium abgespeichert worden, z.B. auf der Festplatte eines Simulationscomputers.

Das virtuelle Fahrzeug befährt in der dreidimensionalen virtuellen Simulationsumgebung eine virtuelle Straße mit Gefälle. Der virtuelle Sensor weist einen Sichtbereich auf, in dem er die virtuelle Simulationsumgebung erfasst. Dabei werden nun durch die translatorische Bewegung des virtuellen Fahrzeugs hervorgerufene Fahrzeugdynamikbewegungen ermittelt, nämlich ein Nicken, ein Gieren, ein Wanken und ein Vertikalbewegen des virtuellen Fahrzeugs.

Der virtuelle Sensor ist vorliegend ein virtueller LIDAR-Sensor, der starr mit dem virtuellen Fahrzeug verbunden ist. Der virtuelle Sensor kann grundsätzlich aber auch ein virtueller Ultraschallsensor, ein virtueller RADAR-Sensor oder eine virtuelle Kamera sein. Bei dem Ermitteln der durch die translatorische Bewegung des virtuellen Fahrzeugs hervorgerufenen Fahrzeugdynamikbewegung werden vorliegend die Masse des virtuellen Fahrzeugs, die Geometrie des virtuellen Fahrzeugs, die Masseverteilung des virtuellen Fahrzeugs, die Federung des virtuellen Fahrzeugs und die Dämpfung des virtuellen Fahrzeugs berücksichtigt.

In Schritt S2 werden synthetische Sensordaten mit dem virtuellen Sensor durch Erfassen der von dem virtuellen Fahrzeug durchfahrenen virtuellen Simulationsumgebung in dem Sichtbereich des virtuellen Sensors erzeugt. Dabei wird die durch die simulierten Fahrzeugdynamikbewegungen des virtuellen Fahrzeugs verursachte Veränderung des Sichtbereichs des virtuellen Sensors berücksichtigt, in dem der virtuelle Sensor die von dem virtuellen Fahrzeug durchfahrene virtuelle Simulationsumgebung erfasst. Der Sichtbereich des virtuellen Sensors ist also nicht nur gegeben durch die eigentliche Translationsbewegung des virtuellen Fahrzeugs innerhalb der Simulationsumgebung sondern auch durch die Fahrzeugdynamikbewegungen. So beeinflusst z.B. ein Kurvenfahren oder auch ein Abbremsen oder Beschleunigen den Sichtbereich des virtuellen Sensors.

In Schritt S3 werden dann die erhaltenen synthetischen Sensordaten als Testdaten zum Testen eines einen Sensordatenstrom auswertenden Steuersystems eines Kraftfahrzeugs bereitgestellt, nämlich durch Abspeichern auf einem nichtflüchtigen, computerlesbaren Speichermedium, wie der Festplatte des Simulationsrechners.

In Schritt S4 schließlich werden die auf dem nichtflüchtigen, computerlesbaren Speichermedium abgespeicherten synthetischen Sensordaten zum Testen eines einen Sensordatenstrom auswertenden Steuersystems oder einer Komponente davon verwendet. Das einen Sensordatenstrom auswertende Steuersystem ist vorliegend ein Fahrerassistenzsystem für eine Kraftfahrzeug, so damit, wie weiter oben erläutert, vor seinem realen Einsatz unter quasi-realen Bedingungen getestet werden kann.

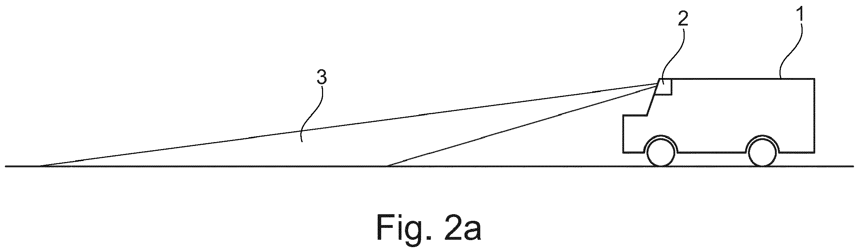

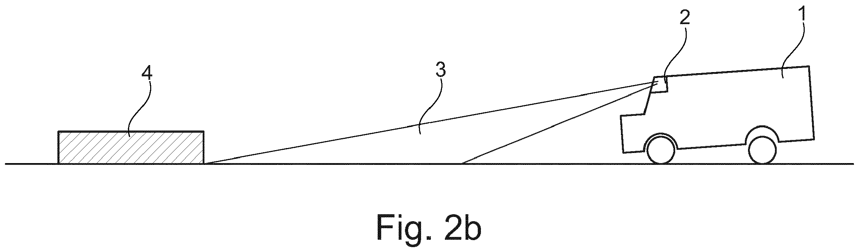

Im Schritt des Erzeugens der synthetischen Sensordaten mit dem virtuellen Sensor wird also die durch die simulierte Fahrzeugdynamikbewegung des virtuellen Fahrzeugs verursachte Veränderung des Sichtbereichs des virtuellen Sensors berücksichtigt, was insbesondere in extremen Fahrsituationen hilfreich ist. Bei starkem Beschleunigen, bei starkem Abbremsen aber auch bei Wankbewegungen in Kurven kann es nämlich zu einer erheblichen Änderung des Sichtbereichs des an einem Fahrzeug angebrachten Sensors kommen. Das ist schematisch in den Fig. 2a und 2b dargestellt:
Fig. 2a zeigt eine unbeschleunigte Fahrt eines virtuellen Fahrzeugs 1, also eine Fahrt mit konstanter Geschwindigkeit. Ein an dem virtuellen Fahrzeug 1 befestigter virtueller Sensor 2 hat einen vorbestimmten Sichtbereich 3 mit dem ein gewisser Bereich vor dem virtuellen Fahrzeug 1 erfasst wird. Kommt es nun zu einer starken Bremsung des virtuellen Fahrzeugs 1, wie bei einer in Fig. 2b dargestellten Vollbremsung, so verändert sich der Sichtbereich 3 des virtuellen Sensors 2. Durch das Nicken des virtuellen Fahrzeugs 1 neigt sich auch der virtuelle Sensor 2 nach vorne, so dass die Umgebung des virtuellen Fahrzeugs 1 nur noch in einem weniger weit von dem virtuellen Fahrzeug 1 entfernten Bereich als vorher während der unbeschleunigten Fahrt des virtuellen Fahrzeugs 1 erfasst wird. Der bei der Bremsung nicht mehr erfasste Bereich 4 ist in Fig. 2b schraffiert dargestellt. Für die Simulation der Fahrsicherheit kann die Berücksichtigung dieses veränderten Sichtbereichs 3 des virtuellen Sensors 2 sehr hilfreich sein.

### Bezugszeichenliste

| | |
|---|---|
| virtuelles Fahrzeug | 1 |
| virtueller Sensor | 2 |
| Sichtbereich des virtuellen Sensors | 3 |
| nicht mehr erfasster Bereich | 4 |

## Patentansprüche

1. Computerimplementiertes Verfahren zum Erzeugen von Testdaten zum Testen eines einen Sensordatenstrom auswertenden Steuersystems eines Kraftfahrzeugs, mit folgenden Verfahrensschritten:
simuliertes Durchfahren wenigstens eines Teils einer virtuellen Simulationsumgebung mit einem einen virtuellen Sensor (2) tragenden virtuellen Fahrzeug (1) durch Vorgabe einer translatorischen Bewegung des virtuellen Fahrzeugs (1) in der virtuellen Simulationsumgebung, wobei der virtuelle Sensor (2) einen Sichtbereich (3) aufweist, in dem er die virtuelle Simulationsumgebung erfasst,
Erzeugen synthetischer Sensordaten mit dem virtuellen Sensor (2) durch Erfassen der von dem virtuellen Fahrzeug (1) durchfahrenen virtuellen Simulationsumgebung in dem Sichtbereich des virtuellen Sensors (2) und
Bereitstellen der synthetischen Sensordaten als Testdaten zum Testen eines einen Sensordatenstrom auswertenden Steuersystems eines Kraftfahrzeugs, wobei
im Schritt des Durchfahrens wenigstens eines Teils der virtuellen Simulationsumgebung mit dem den virtuellen Sensor (2) tragenden virtuellen Fahrzeug (1) wenigstens eine durch die translatorische Bewegung des virtuellen Fahrzeugs (1) hervorgerufene Fahrzeugdynamikbewegung ermittelt wird, wobei die Fahrzeugdynamikbewegung ein Nicken und/oder ein Gieren und/oder ein Wanken und/oder ein Vertikalbewegen des virtuellen Fahrzeugs (1) umfasst, und
im Schritt des Erzeugens der synthetischen Sensordaten mit dem virtuellen Sensor (2) die durch die simulierte Fahrzeugdynamikbewegung des virtuellen Fahrzeugs (1) verursachte Veränderung des Sichtbereichs (3) des virtuellen Sensors (2) berücksichtigt wird, in dem der virtuelle Sensor (1) die von dem virtuellen Fahrzeug (1) durchfahrene virtuelle Simulationsumgebung erfasst.

2. Computerimplementiertes Verfahren nach Anspruch 1, wobei der virtuelle Sensor (2) ein virtueller Ultraschallsensor, ein virtueller LIDAR-Sensor, ein virtueller RADAR-Sensor oder eine virtuelle Kamera ist.

3. Computerimplementiertes Verfahren nach Anspruch 1 oder 2, wobei eine Mehrzahl von virtuellen Sensoren (2) von dem virtuellen Fahrzeug getragen wird.

4. Computerimplementiertes Verfahren nach einem der vorhergehenden Ansprüche, wobei die virtuelle Simulationsumgebung dreidimensional ist.

5. Computerimplementiertes Verfahren nach Anspruch 4, wobei die dreidimensionale virtuelle Simulationsumgebung eine virtuelle Straße mit Gefälle umfasst, auf der das virtuelle Fahrzeug (1) fährt.

6. Computerimplementiertes Verfahren nach einem der vorhergehenden Ansprüche, wobei beim Ermitteln der durch die translatorische Bewegung des virtuellen Fahrzeugs (1) hervorgerufenen Fahrzeugdynamikbewegung Folgendes berücksichtigt wird: die Masse des virtuellen Fahrzeugs (1) und/oder die Geometrie des virtuellen Fahrzeugs (1) und/oder die Masseverteilung des virtuellen Fahrzeugs (1) und/oder die Federung des virtuellen Fahrzeugs (1) und/oder die Dämpfung des virtuellen Fahrzeugs (1).

7. Computerimplementiertes Verfahren nach einem der vorhergehenden Ansprüche, wobei die virtuelle Simulationsumgebung vorab erstellt und auf einem nichtflüchtigen, computerlesbaren Speichermedium abgespeichert ist.

8. Computerimplementiertes Verfahren nach einem der vorhergehenden Ansprüche, wobei der virtuelle Sensor (2) starr an dem virtuellen Fahrzeug (3) befestigt ist.

9. Nichtflüchtiges, computerlesbares Speichermedium mit darauf abgespeicherten synthetischen Sensordaten, die mit dem Verfahren gemäß einem der vorhergehenden Ansprüche erhalten worden sind.

10. Verwendung der auf dem nichtflüchtigen, computerlesbaren Speichermedium nach Anspruch 9 abgespeicherten synthetischer Sensordaten zum Testen eines einen Sensordatenstrom auswertenden Steuersystems.

11. Verwendung nach Anspruch 10, wobei das einen Sensordatenstrom auswertende Steuersystem ein Fahrerassistenzsystem für eine Kraftfahrzeug ist.
